# EUROPEAN PATENT SPECIFICATION

(11) **EP 4 517 807 B1**
(45) Date of publication and mention of the grant of the patent: **22.10.2025**
(21) Application number: 23194697.1
(22) Date of filing: 31.08.2023
(51) Int. Cl.: H01L 23/053, H01L 23/057

(54) **POWER SEMICONDUCTOR MODULE, TERMINAL STRUCTURE AND METHOD**
LEISTUNGSHALBLEITERMODUL, ANSCHLUSSSTRUKTUR UND VERFAHREN
MODULE SEMI-CONDUCTEUR DE PUISSANCE, STRUCTURE DE BORNE ET PROCÉDÉ

(43) Date of publication of application: 05.03.2025
(73) Proprietor: Hitachi Energy Ltd, 8050 Zürich (CH)
(72) Inventor: Santolaria, Lluis, 4600 Olten (CH); Truessel, Dominik, 5620 Bremgarten (CH)
(74) Representative: Michalski Hüttermann & Partner Patentanwälte mbB

(56) References cited:
- EP-A1- 2 903 024
- WO-A1-2020/033124
- JP-A- 2014 049 593
- US-A1- 2013 307 135
- US-A1- 2022 310 409

## Description

### Technical Field

The invention relates to a power semiconductor module comprising a terminal structure configured to provide an external electrical interface for main power transmission and/or for control signal transmission. The invention further relates to a terminal structure for a power semiconductor module. The invention further relates to a method to produce a power semiconductor module.

### Background Art

Power semiconductor modules typically have terminal structures providing external electrical interfaces in order to conduct electricity and/or signals. The terminal structures typically comprise electrically conductive parts coupled on an end away from the respective external electrical interface especially to a power semiconductor device of the power semiconductor module.

It is of interest to provide enhancement with regard to the terminal structures, for example when only few terminal structures are needed due to cost-effective small-scale production or with respect to improving electrical and/or thermal properties.

US 2022/0310409 A1 describes a power semiconductor module comprising a terminal structure configured to provide an external electrical interface.

### Summary of invention

It is therefore an object of the invention to provide solutions with respect to a power module where the electrical and/or thermal properties and/or manufacture is/are improved. Particularly it is an object to avoid or reduce disadvantages of known solutions.

The object of the invention is solved by the features of the independent claims. Preferred implementations are detailed in the dependent claims, the description and the figures.

The invention is defined by the features of the independent claims.

In other words, particularly, disclosed is a power semiconductor module with an enclosure and a substrate arrangement. The substrate arrangement has a chip connected to a metallic layer which chip is housed substantially by means of the enclosure. Furthermore, the power semiconductor module has at least one external electrical interface, for example with an electrical connector, which is meant for transmission of electric power and/or control signals, especially with the environment and/or the specific application, and electrically coupled with the substrate arrangement, particularly the chip, and which is typically accessible outside of the power semiconductor module, for example on/at the enclosure. The external electrical interface is provided by an electrical conductor, such as a metallic component. The external electrical interface may be a separate part attached to the electrical conductor or formed by the electrical conductor itself. It is suggested to make the external electrical interface and/or electrical conductor by means of a primary shaping process such as casting and/or molding and/or forming. Furthermore, the invention suggests a corresponding electrical conductor. Furthermore, the invention suggests a corresponding manufacturing method with respect to the power semiconductor module.

By means of the invention and by means of aspects described in the present application, and enhanced power semiconductor module is provided that can be produced/manufactured more easily.

The invention provides more flexibility in production, especially when the lot size is relatively small. Due to the invention, cost of production may be reduced, for example due to lower tooling cost compared to a well-known solution of terminal structures typically made of stamped and bent metal sheets. Furthermore, the flexibility of shaping the terminal structure, particularly the electrical conductor(s) forming and/or providing the external electrical interface, is enhanced.

The invention provides that a metal forming/bending process of the terminal structure, such as stamping and/or bending of metal sheets, is fully substituted by the primary forming process, such as casting or sintering or 3D printing of metal. Normally, tooling costs for metal forming/bending processes, such as stamping and/or bending, are higher than for primary forming processes, while only at high production volumes the costs per terminal structure are lower with metal forming/bending processes. Thus, tooling costs for making the terminal structure can be reduced when primary forming processes are used. It is possible to make products that come with a lower production volume or prototype series, which products would otherwise not have been economical in production.

Furthermore, the invention provides that thermal losses could be reduced due to the possibility for complex and individual geometries to be shaped by primary forming processes. It is possible to manufacture complex terminal structures with complex shapes, especially as auxiliary terminals for control signal transmission, of one single piece, e.g. for an improvement of the electromagnetic behavior. Bottlenecks with respect to electrical current due to Ohmic losses may be avoided or at least substantially reduced by locally thicker structures, which are easily possible using the primary forming process.

Furthermore, the invention provides that typically the surface area of the terminal structure is increased on a micro scale relative to prior art solutions. For example, the surface roughness, e.g. roughness value Ra, may be increased resulting in an enlarged surface area in contact to air. This may result in that the convective cooling function is enhanced. Additionally, heat flow inside the terminal structure may be enhanced. For example, the heat dissipation or electrical resistance can be improved, or the disadvantages e.g. of sintered material having lower thermal and electrical conductivity compared with bulk or sheet material can be compensated.

It is also possible to optimize the shape of the terminal structure better with respect to the flow of electricity which reduces weight and material cost. A reduction in weight is both beneficial for transport after manufacture and for the later use of the module in any mobile application.

Further advantageous implementations of the invention are given as follows. The features named in the implementations may be individually combined with each other or considered alone. The features may be considered in the method and/or in the power semiconductor module.

The at least one metallization layer refers to a layer or coating of metal or metal alloy material deposited onto a substrate, such as an insulation layer or another layer or substrate. The at least one metallization layer is for example configured for the purpose to provide electrical conductivity, bonding, and/or other functional attributes. Common methods of providing, especially depositing, the at least one metallization layer may be a coating process, a lamination process and/or a brazing process. The choice of deposition method can influence the thickness, uniformity, grain structure, and other properties of the at least one metallization layer.

The terminal structure typically refers to an arrangement including the at least one electrical conductor, most of the times including a plurality of electrical conductors. Typically, the terminal structure includes all the electrical conductors of the power semiconductor module which are configured for providing external electrical interfaces. So it may be that two electrical conductors are located distant to one another, but shall be included in the "terminal structure". In other words, the terminal structure may comprise one, two or more electrical conductors. It may be that the terminal structure comprises a plurality of electrical conductors (like two or more), wherein all of them, are shaped by the primary forming process.

An electrical conductor is meant as a component configured for conducting electrical current and/or electricity. The electrical conductor comprises or consists of a material that is electrically conductive, especially a material different from metal, like carbon in the form of graphite or an electrically conductive polymer. The electrical conductor may be a metal part, a wire, a cable or the like. The electrical conductor may be a structural component in that it is a solid and/or inflexible.

The terminal structure provides at least one external electrical interface. The terminal structure provides the external electrical interface monolithically, e.g. as a section or part or area of the terminal structure. Alternatively or additionally, the terminal structure may provide the external electrical interface as a component of the terminal structure, especially which component is attached in an electrically conductive manner to the electrical conductor. In other words, particularly, the external electrical interface and the electrical conductor may be one integral part or different parts being connected to each other.

The at least one external electrical interface can be used for power transmission, e.g. for transmission of large currents, e.g. above 10 A, 50 A, 100 A or 500A. The terminal structure is hence typically configured for handling such large currents by appropriate size of the at least one electrical conductor. The at least one external electrical interface can be used for control signal transmission, e.g. for transmission of small currents, e.g. below 1 A or 10 A, which control signals may be configured for control of the power semiconductor device. For example, the external electrical interface may comprise means for an electrical connection, e.g. a connector, a screw, a bolt, a thread or the like. For example, the external electrical interface may provide an element to facilitate a joining connection e.g. with an external busbar.

The primary forming process in the sense intended in the present invention relates to a manufacturing process preferably according to DIN 8580, 2022-12-00 entitled "Fertigungsverfahren" or "Manufacturing processes - Terms and definitions, division". In a primary forming process, for example, manufacturing of a solid body from shapeless material by creating the cohesion is conducted, wherein the material properties of the workpiece appear in a determinable manner. Thus, e.g., sintering, casting or additive manufacturing are understood as a primary forming process. Particularly, the manufacturing is conducted using a primary forming tool that provides the shape of the terminal structure by a corresponding inner cavity, particularly the at least one electrical conductor, in its interior.

Sintering the at least one electrical conductor may be conducted at a sintering temperature of at least 200 °C, especially at least 260 °C. Particularly, sintering is conducted with at least 300 °C and/or up to 1400 °C. For example, copper or copper alloy may be sintered with at least 900 °C and/or up to 1200 °C, particularly with at least 1000 °C and/or up to 1080 °C. For example, aluminum or aluminum alloy may be sintered with at least 400 °C and/or up to 650 °C, particularly with at least 500 °C or at least 550 °C and/or up to 620 °C. After sintering, the at least one electrical conductor and/or terminal structure may be cooled down, particularly to room temperature.

Sintering the at least one electrical conductor may be conducted using particles suitable for sintering, especially including metallic particles, particularly with an average size in a range between 1 to 10 micrometers, or above 10 or 100 micrometers. The particles suitable for sintering may additionally include nano-particles, the nano-particles optionally comprising or consisting of metal, preferably similar to or the same as the metallic particles. Nano-particles may include an average size of the particles below below 1 or 0.1 micrometers (i.e. below 1000 nanometers or below 100 nanometers). Nano-particles may enhance electrical or thermal properties by means of increasing density or reducing porosity. The nano-particles may be arranged in specific regions of the terminal structure to be formed, e.g. in vicinity of a contact surface and/or an external electrical interface to be provided by the terminal structure. The nano-particles may be arbitrarily spread within the terminal structure, e.g. to fill voids due to larger size of other particles, e.g. the particles suitable for sintering, especially the metallic particles.

The primary forming process sintering is different from a joining process known as silver or copper sintering. For example, the power semiconductor device can be mechanically connected to the substrate structure by a soldering process, a gluing process or by the silver or copper sintering process. Soldering, gluing or silver / copper sintering may be conducted for connecting the terminal structure to the substrate structure in an electrically conductive manner and including mechanical coupling. Silver sintering may comprise depositing a layer of micron- or submicron-size metallic particles on a bonding area of the substrate structure and/or any other interface; positioning the component to be silver sintered on the layer of metallic particles; sintering the component and the joining partner with the bonding area and/or any other interface together by applying heat and pressure especially to the layer; wherein the heat and pressure can be applied by a fluid, especially a liquid, or by a tool. A silver sintering process typically includes a certain pressure (for example more than 10 MPa; however, pressure-less sintering is possible in some cases) and/or a certain process temperature (around 200 to 350 °C). Typically, the silver sintering process is performed in sequence using a hydraulic press with an integrated heating plate (also called hot press) or in a batch process using a pressurized and heated oil bath. As such, silver sintering may typically not provide a primary forming tool having the shape of the terminal structure, but can rather be seen similar or as an alternative to soldering or gluing.

Casting or molding the at least one electrical conductor may be conducted at a temperature that at least equals the melting temperature of the material to be casted or molded. For example, casting may be conducted at a temperature of at least 660 °C for aluminum or aluminum alloy. For example, casting may be conducted at a temperature of at least 1085 °C for copper or copper alloy. After casting, the at least one electrical conductor and/or terminal structure may be cooled down, particularly to room temperature.

According to said DIN 8580, the primary forming process is meant as the manufacturing process in main group 1 entitled in German "Urformverfahren".

Additive manufacturing is understood as a primary forming process following the classification of said DIN 8580, 2022-12-00, sub group 1.10. Said sub group 1.10 furthermore refers to DIN EN ISO/ASTM 52900:2022-03 entitled "Additive manufacturing - General principles - Fundamentals and vocabulary".

The substrate structure may have a plate-shape and/or substantially flat shape. The substrate structure may have a top side and particularly a bottom side opposite to and/or facing away from the top side.

The substrate structure may have a top metallization layer as one of the at least one metallization layer, particularly arranged on/at the top side. The substrate structure may have a bottom metallization layer as one of the at least one metallization layer, particularly arranged on/at the bottom side. The at least one metallization layer may comprise two or more metallization layers.

The power semiconductor device may be arranged, and particularly electrically and mechanically connected to, the at least one metallization layer, e.g. soldered, particularly on/at the top side.

The power semiconductor module is, for example, meant to be a power module in a vehicle to convert direct current from a battery to alternating current for an electric motor, for example, in hybrid vehicles or plug-in electric vehicles, or in a train like a commuter train. Alternatively or additionally, the power semiconductor module is configured for changing frequencies of voltage and/or current for optimum motor operation.

The module housing at least substantially has and/or forms an interior to accommodate the power semiconductor device. The module housing may have at least one side wall and/or an upper cover. There may be four sidewalls forming a square, cube and/or rectangular shape with the upper cover closing an open side thereof. The Cover and the sidewalls may form an integral part or may be different parts which are joined together. The module housing may have a pot shape to be closed by the substrate structure. The upper cover is meant to be located opposite the substrate structure. Thereby, a closable space for the top side and/or the power semiconductor devices may be provided. The space can be filled with sealing material like dielectric gel or potting resin; alternatively or additionally the module housing can be formed by a solid body prepared e.g. by injection or transfer molding. When the substrate structure is placed and/or fastened to the module housing facing with a top side the module housing, the power semiconductor device(s) can be accommodated, particularly located and/or protected inside the module housing.

Plate-shape means that a shape is flat and/or at least substantially extends towards two of three dimensions. A plate may be flat in one direction but substantially elongated in two directions, while all three directions are perpendicular to each other. Particularly, each of a width and a length of a plate is at least by a factor of 2, 5, 10, 50, 100 or more larger than a thickness in order to be considered having a plate-shape. A plate-shape may still contain an uneven topography on the top side and/or the bottom side of the substrate structure, e.g. the side including power semiconductor devices, insulation grooves, chips, wires, cooling structures like cooling fins and the like.

It is particularly understood that the substrate structure has a plate-shape when a typically substantial part of the substrate structure, e.g. base plate / bottom plate or insulation layer, or metallization layers, has a plate-shape. A substantial part preferably is considered as a part that makes up for at least 10 % or 50 % or 75 % of the weight and/or volume of the substrate structure, which typically is true for one or both of bottom plate and insulation layer. Particularly, it is most preferred that the insulation layer and/or a/the bottom plate has a plate-shape and/or is at least substantially plate-shaped. It is noted that the at least one metallization layer and/or metallization pattern(s) may be considered plate-shaped.

The top side may not have an entirely flat surface and particularly exhibits a specific topography e.g. due to insulation grooves between metallization patterns, power conductor devices and/or other features. The top side pertains to substantially one side of the substrate structure e.g. including the at least one metallization layer and chips , wherein the bottom side pertains to substantially another side of the substrate structure e.g. for placement of the entire power semiconductor module, e.g. to a cooler or heat sink for heat transfer and the like.

The substrate structure may have an insulation layer with a metallization layer on the top side as a top metallization layer, and optionally with a metallization layer opposite the top metallization layer as a bottom metallization layer. The insulation layer may comprise for electrical insulation a ceramic material and/or a resin sheet typically filled with inorganic particles or fibers. The insulation layer is typically a dielectric layer, e.g. made of a flexible or of a solid material.

The substrate structure may have the insulation layer with a metallization layer at the top side and with a bottom metallization layer at the bottom side of the substrate structure. The insulation layer may be a ceramic layer, e.g. comprising at least one type of a ceramic and/or an oxide, for example aluminum oxide, aluminum nitride, or silicon nitride. The top metallization layer and/or the bottom metallization layer may be a layer attached to and/or coated on the insulation layer. The insulation layer and the at least one metallization layer may be attached to one another, e.g. to form a structural unit.

The at least one metallization layer, especially the top metallization layer and/or the bottom metallization layer, particularly comprise(s) or consists of copper, aluminum, or an alloy therewith. The at least one metallization layer, may have a coating, e.g. a nickel coating for improved corrosion resistance, improved electrical properties, improved bonding properties and/or reduced costs.

The at least one metallization layer, especially the top metallization layer and/or the bottom metallization layer, may be applied and/or generated directly on the insulation layer. The insulation layer may provide structural integrity to the substrate structure (e.g. the insulation layer providing more mechanical stability and/or resistance against bending relative to the at least one metallization layer), the at least one metallization layer may provide electrical interconnection of at least the power semiconductor devices, and/or the bottom metallization layer may provide heat radiation or dissipation means. In some specific power semiconductor module designs, the bottom metallization layer may provide electrical interconnection e.g. when used as a GND layer.

The substrate structure may have a/the bottom plate at the bottom side opposite the top side, optionally with the bottom plate coupled (e.g. directly or indirectly) to the insulation layer, preferably coupled (indirectly) via a metallization layer, such as a bottom metallization layer, and/or (directly) with the bottom metallization layer in between. There may be a joining layer e.g. prepared by soldering, gluing, or silver / copper sintering between the bottom metallization layer and the bottom plate. The bottom plate may comprise or consist of metal or metal composite material, e.g. AlSiC, MgSiC, aluminum, copper, steel and/or other metals or alloys. Particularly, the bottom plate may comprise metal within an alloy and/or within a composite material, particularly AlSiC and/or MgSiC.

The bottom plate may be understood or generally referred to as a base plate or heat sink, e.g. to serve as a base for the power semiconductor module. The bottom plate typically differentiates from the layers (e.g. metallization and/or insulation) particularly by its thickness being preferably above 2 mm or 3 mm and/or below 10 mm or 5 mm, wherein the layers typically exhibit a thickness lower than that. The bottom plate differentiates from the layers (e.g. metallization and/or insulation) particularly by its material preferably comprising by more than 2 wt.-% aluminum, magnesium, carbon, silicon and/or other materials, wherein the layers may exhibit different materials. It may be that the bottom plate is of the same material as the at least one metallization layer, like the bottom metallization layer. It is an option that the bottom plate is of a different material relative to the at least one metallization layer or the bottom metallization layer. The bottom plate may exhibit a plate shape in that it has a solid and flat structure which extends substantially within/along a/the plane. For example, the bottom plate may comprise a bow, a bump and/or a dent and or cooling structures like cooling fins but however is substantially plate-shaped.

The bottom plate may be soldered and/or bonded and/or sintered by silver or copper sintering and/or glued and/or coupled to the insulation layer preferably via the at least one metallization layer. The substrate structure may comprise the insulation layer with the at least one metallization layer at the top side and with the bottom plate at the bottom side of the substrate structure. The insulation layer may be directly bonded, brazed and/or laminated on the bottom plate to provide an insulated substrate, particularly insulated metal substrate.

The insulation layer may be a polymer layer, e.g. comprising at least one type of a polymer, particularly a polymer compound, a resin, a polymer compound layer, a resin layer and/or a resin sheet, typically filled with inorganic particles or fibers. The bottom plate may provide heat radiation or dissipation means as well as a mounting capability, e.g. to a cooling means.

The substrate structure can be provided with the bottom metallization layer and/or the bottom plate on its lower side especially for thermally connecting the substrate structure to a cooler.

The power semiconductor device is electrically and typically mechanically connected to the at least one metallization layer, especially to the top metallization layer. For externally connecting the power semiconductor module, particularly the power semiconductor device, the terminal structure is provided.

The at least one metallization layer, especially the top metallization layer, may provide multiple (metallization) patterns for mounting of power semiconductor devices and/or other electronic devices such as sensors, control devices, and/or passive devices and especially for providing a connection for the terminal structure to provide on the outside the external electrical interface. Patterns of the at least one metallization layer for mounting of the terminal structure may be electrically connected with the power semiconductor devices or other devices or with other patterns of the at least one metallization layer.

The substrate structure can be an integral structure like an insulated metal substrate comprising a metal bottom plate, isolating sheet and top metallization layer. Alternatively there may be only a substrate structure comprising of a ceramic sheet with top and bottom metallization layer, which may be joined to a bottom plate

The power semiconductor device may be in the form of a chip. More than one power semiconductor device may be provided in the power semiconductor module. It may be provided that as the power semiconductor device(s) one or more of a transistor, a diode, and/or switching device is provided, such as insulated-gate bipolar transistor (IGBT) device, metal oxide semiconductor field-effect transistor (MOSFET), high electron mobility transistor (HEMT), and/or the like.

The power semiconductor devices can be mounted on and/or can be a part of the same substrate structure or on several substrate structures for the module housing, e.g. on the substrate structure and on another substrate structure. It is also possible, that there is a common bottom plate, where several setups comprising or consisting of: bottom metallization layer, insulation layer, and top metallization layer, are arranged, e.g. mounted.

All the power semiconductor devices can be of the same type, or there are at least two different types of power semiconductor devices, like diodes and/or transistors. The power semiconductor device may be selected from the group comprising or consisting of a metal-oxide-semiconductor field-effect transistor, MOSFET for short, a metal-insulator-semiconductor field-effect transistor, MISFET for short, an insulated-gate bipolar transistor, IGBT for short, a bipolar junction transistor, BJT for short, a gate turn-off thyristor, GTO for short, a gate commutated thyristor, GCT for short, a junction gate field-effect transistor, JFET for short, a high electron mobility transistor, HEMT for short, and a diode. If there is a plurality of the power semiconductor device, all the power semiconductor devices can be of the same type, or there are different types of power semiconductor devices.

The term 'power semiconductor module' means, for example, that the module is configured for high currents. For example, the power semiconductor module is configured to handle a current of at least 10 A or of at least 50 A or of at least 100 A or of at least 500 A. Correspondingly, the power semiconductor device may be high-power device, particularly a high-power chip.

The at least one metallization layer may be in direct contact with the insulation layer. The insulation layer may be the only layer between two metallization layers. The insulation layer may alternatively be the only layer between a (top) metallization layer and a/the bottom plate.

The insulation layer may comprise one or a plurality of ceramic layers. For example, the ceramic layer may comprise an AIN, Si3Ni, Al2O3, BN, or a resin material filled with particles or fibers of inorganic material. The insulation layer may comprise or consist of at least one isolating resin sheet. The insulation layer may be filled with an inorganic filler like inorganic particles. The at least one inorganic filler can be a ceramic material like AIN, Al2O3, Si3N4, or BN.

The substrate structure provides an electrical contact platform for one, for some or for all the power semiconductor device(s).

The at least one metallization layer may have a thickness of at least 0.2 mm, 0.5 mm, 0,75 mm, 1 mm or more. The thickness of the least one metallization layer may be up to 5 mm, 4 mm, 3 mm, 2 mm, or less. The thickness may be a nominal thickness of the least one metallization layer, especially considered directly after its (raw) manufacture.

The least one metallization layer may be deposited in a coating process, a lamination process, a brazing process, and/or by a direct bonding method, e.g. where molten material is applied on an/the insulation layer and/or on a/the ceramic body.

Bonding may include the terms of soldering, sintering, silver sintering, gluing, brazing, and/or other methods.

The at least one metallization layer may have an isolation groove to form individual electrically conducting sections or patterns of the at least one metallization layer and/or at least one electrical circuit, particularly at least substantially comprising the same thickness. More than one isolation groove may be provided. Preferably above the at least one metallization layer, particularly in individual electrical connection to the electrically conducting sections, particularly above and in contact to the at least one metallization layer, the power semiconductor device(s) is/are located.

In a first preferred implementation the module housing has at least one passage for the at least one electrical conductor. The at least one passage may be in the form of a bore and/or a recess. The at least one electrical conductor may extend from the substrate structure through the passage to form the external electrical interface. Particularly, the at least one electrical conductor may extend from an interior of the power semiconductor module to an exterior of the power semiconductor module. The at least one electrical conductor may be surrounded by the module housing in the at least one passage. The module housing may form the interior. In other words, particularly, the at least one electrical conductor may extend from an inside to an outside. The at least one electrical conductor may be shaped to at least substantially seal the at least one passage. The passage helps in manufacture and mounting and in making the module robust against circumferential influences. The passage may support the terminal structure.

In the implementation falling under the scope of the present invention the at least one electrical conductor is shaped by casting, injection molding, sintering and/or additive manufacturing. Additive manufacturing is particularly also known as 3D printing. Particularly, the at least one electrical conductor is monolithically formed from an electrically conducting material, e.g. in one piece and/or as a solid part. The at least one electrical conductor is typically at least partially or at least substantially made of the electrically conducting material, especially graphite and/or electrically conductive polymer compound and/or metal, particularly a metal alloy and/or a metal compound. Such primary forming processes help in a cost-efficient manufacture and comprise low tooling costs relative to metal forming processes like bending and stamping, especially for small volumes. Also, such primary forming processes provide high flexibility in the shape, help in producing components with a rather homogeneous microstructure with little compressive stresses and in many cases with a high fatigue life. Also, it is easy to make parts with composite materials, like metal alloys, carbon and/or polymers combined.

Particularly, the terminal structure, especially the at least one electrical conductor, is manufactured and/or shaped free of a bending process and/or free of a stamping process. The terminal structure, especially the at least one electrical conductor, may especially not be mechanically bent or mechanically formed, in manufacture and/or shaping. As such, particularly, the terminal structure, especially the at least one electrical conductor, has a homogeneous distribution of grain size, tensile stresses, compressive stresses.

In another preferred implementation the at least one electrical conductor comprises an electrically non-conductive core that has an electrically conductive surface layer. The electrically non-conductive core may be a plastic part, especially consisting of a polymer compound, or a ceramic part. The electrically conductive surface layer may comprise an electrically conductive polymer compound and/or metal and/or carbon, particularly nickel, copper, aluminum, chromium, iron and/or graphite. In other words, particularly, the at least one electrical conductor is shaped/formed from an electrically non-conductive material to form a solid component therefrom, and has on the solid component an electrically conductive coating and/or surface layer, especially the electrically conductive coating and/or surface layer comprising nickel, copper, aluminum, chromium, iron, and/or graphite. Particularly, the terminal structure may be made by means of injection molding and/or additive manufacturing of a plastic which is after injection molding or additive manufacturing coated with electrically conductive material. Particularly, for use in control signal transmission such an electrical conductor is advantageous. In addition, such an implementation helps in development due to low investment cost for making the parts and/or for tooling.

It may be that the at least one electrical conductor comprises an electrically conductive core that has an electrically non-conductive surface layer. In other words, the electrical conductor may be embedded in an electrically non-conductive coating? material and/or in a molding material. This may provide electrical isolation and may enhance creep resistance or safety.

In another preferred implementation the at least one electrical conductor is shaped from metal particles or particles of electrically conductive ceramics, especially by means of additive manufacturing. The at least one electrical conductor has a porous surface and/or is porous inside. The porosity may amount for example at least 0,1%, 0,25%, 0,5%, 0,75%, 1%, 2,5% or 5%. The porosity may amount for example up to 5% up to 10 %. The porosity may have close pores. By means of porosity, the amount of used material can be reduced, which may be helpful especially when only little current needs to be conducted like it is the case for control signal transmission. A porous surface may increase surface area for enhancing convective heat transfer away from the electrical conductor.

Particularly, porosity or void fraction is a measure of the void (i.e. "empty") spaces in a material, and is a fraction of the volume of voids over the total volume, between 0 and 1 or between 0% and 100%. Several methods can be employed to measure porosity: Direct methods (e.g. determining the bulk volume of the porous sample, and then determining the volume of the skeletal material with no pores (pore volume = total volume - material volume). Optical methods (e.g. determining the area of the material versus the area of the pores visible under the microscope). The "areal" and "volumetric" porosities are equal for porous media with random structure. Computed tomography method (using industrial CT scanning to create a 3D rendering of external and internal geometry, including voids. Then implementing a defect analysis utilizing computer software). There are more methods known in the art to measure porosity.

In another preferred implementation the at least one electrical conductor comprises or consists of aluminum and/or an aluminum alloy. Aluminum or an alloy thereof is lightweight and a comparably good electrical and thermal conductor. Aluminum also has a relatively low melting point which helps in primary forming processes that may bring materials up to their melting points.

In another preferred implementation the at least one electrical conductor comprises or consists of copper and/or a copper alloy. Copper or an alloy thereof has a very good electrical and thermal conductivity and is relatively easy to manufacture.

In another preferred implementation the at least one electrical conductor comprises a polymer compound, for example plastic. The polymer compound may comprise electrically conductive material, for example, metal or carbon, especially in the form of particles. The at least one electrical conductor may be coated, especially with the electrically conductive material.

In another preferred implementation the at least one electrical conductor has two or more sections of different thicknesses and/or has a thickness variable, particularly by at least 10 %, along its extension. The direction of extension is typically considered with respect to the current flow. For example, the electrical conductor may substantially have section with increased thickness where high currents flow and may substantially have a section with reduces thickness where low currents flow, which sections may be adjacent to one another. The electrical conductor may have a flat cross-section, wherein a top and a bottom side may be flat, especially parallel to one another; the smaller sides may be curved or convex or the like. In a cross-section, the electrical conductor thus preferably comprises on opposing sides two substantially parallel sides and on two other opposing sides at least partially two curves and/or non-parallel sides. In a cross-section, the electrical conductor may not be of a rectangular shape. The electrical conductor may thus be adapted to complex shapes within a power semiconductor module required per construction.

In another preferred implementation the at least one electrical conductor has a contact surface configured for electrical connection to the substrate structure. The at least one electrical conductor extends monolithically from the contact surface to the external electrical interface. Alternatively or additionally, the contact surface may have a surface roughness lower (like surface roughness Ra) than other surfaces of the at least one electrical conductor and/or may be finish-machined by means of/with a cutting process and/or a grinding or polishing process. This lowers the electrical resistance and enhances overall electrical efficiency.

Surface roughness is typically understood as the shorter frequency of real surfaces relative to the troughs. Surfaces typically embody a complex shape made of a series of peaks and troughs of varying heights, depths, and spacing. Surface roughness is greatly affected by the microscopic asperity of the surface. Surface roughness can be quantifies within a profile roughness parameter, such as Ra, Rq or the like. The profile roughness parameters are included in BS EN ISO 4287:2000 British standard, identical with the ISO 4287:1997 standard. The standard is based on the "M" (mean line) system. There are many different roughness parameters in use, wherein Ra is very common. Other common parameters include Rz, Rq and Rsq. A profile roughness parameter like Ra typically is a dimensional unit that can be measured in micrometer or microinch or the like.

Particularly, the profile roughness parameter such as average roughness, mean surface roughness or Ra, is a specified surface texture parameter. It provides a measure of the height of the texture across a surface. Ra is the average of how far each point on the surface deviates in height from the mean height. In other words, Ra measures the deviation of a surface from a mean height.

The method and/or the power semiconductor module may be improved by providing that the electrically conducting material comprises aluminum, copper, gold, and/or a polymer compound. An alloy or compound or metal-matrix-material or plastic-matrix-material or ceramic-matrix-material may be designed with any of the materials named herein.

The method may comprise the step of coupling the at least one electrical conductor to the substrate structure, particularly by means of soldering and/or welding, especially at a contact surface of the at least one electrical conductor. The method may comprise the step of attaching the module housing to the substrate structure, especially by means of screwing, gluing, clamping and/or bonding, especially after coupling. The module housing may be attached to the substrate structure at the top side and/or away from the bottom side. The step of attaching the module housing to the substrate structure may be conducted after the step of coupling the at least one electrical conductor to the substrate structure.

The module housing may be a molded body. Particularly, the method may including molding, e.g. injection molding or transfer molding, of the module housing.

The method may comprise heating the electrically conducting material in the primary forming process to a temperature of at least 200 °C and/or up to 1500 °C. The temperature may be selected as a function of the melting temperature of the electrically conducting material; for example, the temperature may be selected to be below the melting temperature (especially in case of sintering) or above the melting temperature (especially in case of casting or molding or the like). The electrically conducting material may melt or may not melt. Particularly, the electrically conducting material may melt to get in shape, which in most cases happens during and/or after injection molding, casting or additive manufacturing. Additive manufacturing may also comprise that the electrically conducting material is done by printing below a melting temperature, e.g. a paste with particles, and subsequent baking or sintering process (e.g. if paste contains particles to be connected). Alternatively, the electrically conducting material may at least partially or entirely stay solid, i.e. not melt, which in most cases happens during sintering or in some cases additive manufacturing.

In case of sintering, the pressure may be selected as a function of temperature, material, and/or particle size.

The term 'or' may be replaced by 'and/or' throughout the present disclosure. As such, where 'or' is used, it is not necessarily meant that merely alternatives are named.

### Brief description of drawings

These and other aspects of the invention will be apparent from and elucidated with reference to the implementations described hereinafter. Figs. 1 - 3 fall under the scope of the present invention.

In the drawings:
Fig. 1 shows a schematic cross-section of a power semiconductor module with a module housing, a substrate structure and a terminal structure, wherein the terminal structure forms by means of two electrical conductors and external electrical interfaces
Fig. 2 shows a power semiconductor module in a perspective view; and
Fig. 3 shows a method according to the invention.

### Description of implementations

The description contains procedural or methodical aspects upon describing structural features of the power semiconductor module 1; the structural features can be understood well in that way. It is emphasized to the reader that such structural features can be lifted from the described context without hesitation or the question of an intermediate generalization to form aspects of the invention. It is also emphasized to the reader that any the structural features described in the following can be understood as individual aspects of the invention to distinguish from known solutions, despite being possibly lifted from the context.

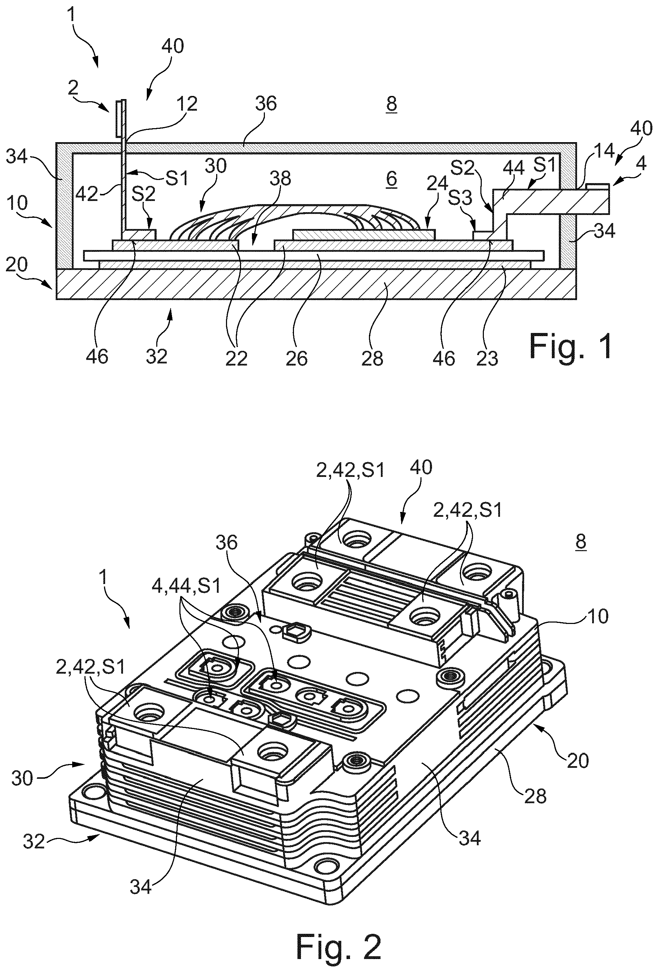

Fig. 1 shows a power semiconductor module 1. The module 1 comprises a module housing 10, a substrate structure 20 and a terminal structure 40.

The substrate structure 20 comprises a bottom plate 28, an insulation layer 26 with a metallization layer 22 as a top metallization layer and a metallization layer 23 as a bottom metallization layer, wherein the bottom metallization layer 23 is attached, e.g. soldered, silver/copper sintered and/or bonded, to the bottom plate 28. The layers 22, 23 and 26 form together with the bottom plate 28 a structural unit.

On a top side 30 of the substrate structure 20, where the top metallization layer 22 is arranged, there is a power semiconductor device 24 arranged, which device 24 is in the form of a chip soldered, sintered, or glued to the top metallization layer 22. Thus, the chip is mechanically and electrically connected and/or coupled to the top metallization layer 22.

The substrate structure 20 substantially has a plate-shape with the top side 30 and a bottom side 32 opposite the top side 30. The substrate structure 20 may have the top metallization layer 22 as one of at least one metallization layer 22, 23 and arranged on/at the top side 30. The bottom plate 32 is mechanically coupled to the insulation layer 26 via the bottom metallization layer 23.

The substrate structure 20 comprises at least one metallization layer 22, 23, namely two metallization layers 22, 23. The top metallization layer 22 and the bottom metallization layer 23 each are one of the at least one metallization layer 22, 23, especially of the two metallization layers 22, 23. The top 22 and bottom 23 metallization layers are formed on opposite sides 30, 32 on the insulation layer 26, which layer 26 e.g. consists of a ceramic material or isolating resin material. The at least one metallization layer 22, 23, especially the top 22 and bottom 23 metallization layers, consist of copper or a copper alloy or of aluminum or an aluminum alloy. The top metallization layer 22 provides electrical interconnection of the power semiconductor device 24. The bottom metallization layer 23 provides heat radiation or dissipation means, especially towards the bottom plate 28.

Here, the metallization layers 22, 23 are in direct contact with the insulation layer 26. The insulation layer 26 is the only layer between the top metallization layer 22 and the bottom metallization layer 23. The bottom metallization layer 23 is the only layer between the insulation layer 26 and the bottom plate 28. The bottom metallization layer 23 is bonded to the insulation layer 26 on one side and to the bottom plate 28 on the other side. The metallization layers 22, 23 have a thickness of e.g. 0.5 mm. The metallization layers 22, 23 have been deposited on the insulating layer in a coating process, a lamination process, direct bonding process and/or a brazing process.

The top metallization layer 22 has an isolation groove 38 to form individual electrically conducting sections and/or metallization patterns of the top metallization layer 22 comprising for example the same thickness. Above the top metallization layer 22 and in individual electrical connection to the electrically conducting sections the power semiconductor device 24 is located.

The module housing 10 has and forms an interior 6 to accommodate the power semiconductor device 24. The module housing 10 has side walls 34 and an upper cover 36. The upper cover 36 is located opposite the substrate structure 20. The module housing 10 is attached to the substrate structure 20, particularly to the bottom plate 28. Particularly, the walls 34 are attached/fastened via a contact surface to the substrate structure 20, e.g. bonded or the like. Thus, the power semiconductor device 24 is accommodated.

In Fig. 1, the terminal structure 40 is in the form of two electrical conductors 42, 44.

At least one of the conductors 42, 44 has been shaped by a primary forming process. The conductor 42 is for main power transmission and is shaped - for example - by additive manufacturing or sintering. The conductor 44 is for control signal transmission and is shaped - for example - by metal injection molding or casting, for example made of aluminum alloy or copper alloy. The electrical conductors 42, 44 are electrically and mechanically connected to the substrate structure 20. The electrical conductors 42, 44 comprise and provide external electrical interfaces 2, 4 of the power semiconductor module 1. The external electrical interfaces 2, 4 are in each case connected to the electrical conductors 42, 44, especially bonded thereto. The conductors 42, 44 are soldered, welded, or sintered to the substrate structure 20, especially to the top metallization layer 22.

The module housing 10 has two passages 12, 14, one for each of the electrical conductors 42, 44. The passages 12, 14 are in the form of bores or holes. The electrical conductors 42, 44 each extend from the substrate structure 20 to form the external electrical interfaces 2, 4. The electrical conductors 42, 44 extend from the interior 6 to an exterior 8. The electrical conductors 42, 44 are surrounded by the housing in the corresponding passages 12, 14.

The electrical conductors 42, 44 are monolithically formed from an electrically conducting material, e.g. in one piece and as a solid part. The electrical conductor 42 being made by additive manufacturing or sintering might be porous inside. The porosity is typically at least 0,1% and up to 10 %. The electrical conductors 42, 44 each have sections S1, S2, S3 of different thicknesses, particularly wherein the sections S1, S2, S3 may point in the same or in different directions, e.g. the sections S1, S2, S3 being vertical or horizontal relative to the substrate structure 20. The sections S1, S2, S3 are considered along the elongation of a respective electrical conductor 42, 44 between the substrate structure 20 and the external electrical interface 2, 4. The thicknesses are thus variable along the extension of the electrical conductors 42, 44. Particularly, the conductor 44 has three such sections S1, S2, S3 of different thicknesses.

In a cross section arranged perpendicular to the typical electrical current flow from substrate structure 20 to the respective interface 2, 4, particularly, the electrical conductor 42, 44 has a substantially flat shape with two substantially parallel sides, and with substantially non-parallel sides. In other words, particularly, in the cross section perpendicular to the current flow the electrical conductor 42, 44 may be shaped with only two substantially parallel sides and/or may not be shaped as a rectangular. This increases robustness in terms of mechanical loads with enhanced fatigue life, increases surface area for heat dissipation, enhances user handling due to less sharp edges. At least locally larger thickness also improves current flow and heat flow inside the terminal structure 40, but also reduces heat generation due to Ohmic losses.

The electrical conductors 42, 44 each have a contact surface 46 configured for electrical connection to the substrate structure 20. The electrical conductors 42, 44 extend monolithically from the contact surface 46 to the external electrical interface 2, 4. The contact surfaces 46 have a surface roughness, for example the roughness Ra, lower than the corresponding roughness, for example roughness Ra, of other surfaces (away from the contact surface 46) of the electrical conductor 42, 44.

In specific embodiments, an electrical conductor comprise an electrically non-conductive core that has an electrically conductive surface layer.

Fig. 2 shows another embodiment of the present invention within a perspective view of a power semiconductor module 1 with external electrical interfaces 2, 4 accessible at an exterior 8.

The power semiconductor module 1 has a module housing 10 attached to a substrate structure 20 and a terminal structure 40. The terminal structure 40 is an arrangement of and/or has at least six electrical conductors 42 including the external electrical interfaces 2 made of a copper alloy and at least three electrical conductors 44 including the external electrical interfaces 4.

One of the electrical conductors 44 is made of an injection molded electrically nonconducting polymer compound forming a core which is coated with a copper alloy; this conductor 44 may serve for control signal transmission, wherein other conductors 42 may mainly serve for power transmission at higher electrical currents. Particularly, all six electrical conductors 42 are power terminals for power transmission.

The electrical conductors 42, 44 penetrate passages in the housing 10.

With particular reference to Fig. 1, the interfaces 2, 4 are attached, especially bonded, to the corresponding electrical conductors 42, 44. The electrical conductors 42, 44 are bonded to the substrate structure 20 on a top side 30 and in an interior 6 of the module 1. The electrical conductors 42 have along their extension starting from the substrate structure 20 up to the point where they support the interfaces 2, 4 sections of different thicknesses and/or orientations, wherein in Fig. 1 one section indicated by reference S1 supports the interface 2 visible and accessible at the exterior 8, and another section indicated by reference S1 supports the interface 4 visible and accessible at the exterior 8. In Fig. 2, the electrical conductors 42, 44 themselves form the external electrical interfaces 2, 4 directly by means of sections S1.

The electrical conductors 42 are made by primary forming processes, like injection molding, sintering, casting or the like.

The interior 6 is formed by means of the module housing 10 bonded with a contact surface to a contact surface of the substrate structure 20. The module housing 10 has four side walls 34 in a substantially rectangular arrangement. Particularly, the module housing 10 has an upper cover 36 arranged opposite the substrate structure 20. The upper cover 36 and the side walls 34 are formed monolithically and/or in one piece.

The substrate structure 20 has a metallization layer (not shown) onto which the electrical conductors 42 are electrically and mechanically coupled. On the metallization layer power semiconductor devices in the form of chips are arranged and are both mechanically and electrically coupled (not shown). The metallization layer is coated on an insulation layer (not shown). wherein the insulation layer is attached to a bottom plate 28. The bottom plate 28 has the contact surface for the attachment to the module housing 10. A bottom side 32 is under the bottom plate 28. The bottom plate 28 is typically at least substantially flat at the bottom side 32. In not shown applications the bottom plate 28 may have cooling fins or cooling structures formed on its bottom side.

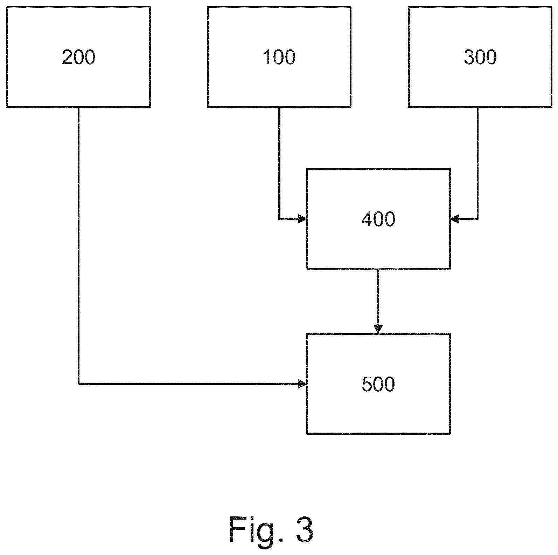

The modules 1 shown in Figs 1 and. 2 have been manufactured using a method according to the invention as shown for example in Fig. 3. Firstly, in this method, a substrate structure 20 with at least one power semiconductor device 24 is being provided in a step referenced with 100. Furthermore, a module housing 10 configured to be attached to the substrate structure 20 to house the power semiconductor device 24 is being provided in a step referenced with 200, typically simultaneously to, before or after providing 100 the substrate structure. In addition, a terminal structure 40 is being manufactured in a step referenced with 300.

The terminal structure 40 has at least one electrical conductor 42, 44 and is being electrically coupled to the at least one power semiconductor device 24 providing at least one external electrical interface 2, 4 for main power transmission and/or for control signal transmission. The interface 2, 4 extends to the substrate structure 20.

The terminal structure 40 has been manufactured in step 300 by shaping an electrically conducting material in a primary forming process.

The conductors 42, 44 have been coupled to the substrate structure 20 by means of soldering, sintering, gluing, or welding at a contact surface 46 and in step referenced by 400. Step 400 is after steps 100 and 300, and preferably before below described step 500.

In another step referenced with 500 the module housing 10 has been attached to the substrate structure 20, for example screwed or bonded, especially after step 400 and after step 200.

### Reference signs list

- 1: power semiconductor module
- 2: external electrical interface
- 4: external electrical interface
- 6: interior
- 8: exterior
- 10: module housing
- 12: passage
- 14: passage
- 20: substrate structure
- 22: metallization layer
- 23: metallization layer
- 24: power semiconductor device
- 26: insulation layer
- 28: bottom plate
- 30: top side
- 32: bottom side
- 34: side wall
- 36: upper cover
- 38: isolation groove
- 40: terminal structure
- 42: electrical conductor
- 44: electrical conductor
- 46: contact surface
- S1: section
- S2: section
- S3: section
- 100: step, providing
- 200: step, providing
- 300: step, manufacturing
- 400: step, coupling
- 500: step, attaching

## Claims

1. Power semiconductor module (1) comprising
a module housing (10),
a substrate structure (20) with at least one metallization layer (22, 23) and at least one power semiconductor device (24) electrically connected to the at least one metallization layer (22, 23), which substrate structure (20) is attached to the module housing (10) to accommodate the power semiconductor device (24), and
a terminal structure (40) electrically connected to the substrate structure (20) and configured for providing an external electrical interface (2, 4) of the power semiconductor module (1) for main power transmission and/or for control signal transmission of the substrate structure (20), wherein
the terminal structure (40) has at least one electrical conductor (42, 44) shaped by casting, injection molding, sintering and/or additive manufacturing, and
the at least one electrical conductor (42, 44) is shaped free of bending and/or free of stamping and
the at least one electrical conductor (42, 44)
is monolithically formed from an electrically conducting material,
has a porous surface and/or is porous inside,
has a contact surface (46) configured for electrical connection to the substrate structure (20), and
extends monolithically from the contact surface (46) to the external electrical interface (2, 4).

2. Power semiconductor module (1) according to the preceding claim, wherein
the module housing (10) has at least one passage (12, 14) for the at least one electrical conductor (42, 44), and
the at least one electrical conductor (42, 44) extends in an interior (6) of the power semiconductor module (1) from the substrate structure (20) to an exterior (8) of the power semiconductor module (1) to form the external electrical interface (2, 4),
particularly wherein the at least one electrical conductor (42, 44) is surrounded by the module housing (10) in the at least one passage (12, 14) and/or wherein the module housing (10) forms the interior (6).

3. Power semiconductor module (1) according to any one of the preceding claims, wherein the electrically conducting material comprises or consists of graphite and/or electrically conductive polymer compound and/or metal, particularly a metal alloy and/or a metal compound.

4. Power semiconductor module (1) according to one of the preceding claims,
wherein the at least one electrical conductor (42, 44) comprises an electrically non-conductive core that has an electrically conductive surface layer, especially the electrically conductive surface layer comprising nickel, copper, chromium, iron, and/or carbon.

5. Power semiconductor module (1) according to one of the preceding claims, wherein the at least one electrical conductor (42, 44) is shaped from metal particles, and wherein a porosity of the at least one electrical conductor (42, 44) is at least 0,1% and up to 10 % and/or has close pores.

6. Power semiconductor module (1) according to one of the preceding claims, wherein the at least one electrical conductor (42, 44) comprises aluminum or consists of an aluminum alloy.

7. Power semiconductor module (1) according to one of the preceding claims, wherein the at least one electrical conductor (42, 44) comprises copper or consists of a copper alloy.

8. Power semiconductor module (1) according to one of the preceding claims, wherein the at least one electrical conductor (42, 44) comprises a polymer compound.

9. Power semiconductor module (1) according to one of the preceding claims, wherein the at least one electrical conductor (42, 44) has two or more sections (S1, S2, S3) of different thicknesses and/or has a thickness variable, particularly by at least 10 %, along its extension.

10. Power semiconductor module (1) according to one of the preceding claims, wherein
the contact surface (46) has a surface roughness lower than other surfaces of the at least one electrical conductor (42, 44) and/or being finish-machined with a cutting process.

11. Terminal structure (40) configured for the power semiconductor module (1) of any one of the preceding claims, wherein
the terminal structure (40) is configured to be electrically connected to the substrate structure (20) and to provide the external electrical interface (2, 4), and
the terminal structure (40) has at least one electrical conductor (42, 44) shaped by casting, injection molding, sintering and/or additive manufacturing, and
the at least one electrical conductor (42, 44) is shaped free of bending and/or free of stamping and
the at least one electrical conductor (42, 44)
is monolithically formed from an electrically conducting material,
has a porous surface and/or is porous inside,
has a contact surface (46) configured for electrical connection to the substrate structure (20), and
extends monolithically from the contact surface (46) to the external electrical interface (2, 4).

12. Method for manufacturing a power semiconductor module (1) according to claim 1, comprising the steps of
providing (100) a substrate structure (20) with at least one power semiconductor device (24),
providing (200) a module housing (10) configured to be attached to the substrate structure (20) to house the at least one power semiconductor device (24),
manufacturing (300) a terminal structure (40) having at least one electrical conductor (42, 44) and configured to be electrically coupled to the at least one power semiconductor device (24) and to provide an external electrical interface (2, 4) for main power transmission and/or for control signal transmission to the substrate structure (20),
coupling (400) the at least one electrical conductor (42, 44) to the substrate structure (20),
attaching (500) the module housing (10) to the substrate structure (20),
wherein
manufacturing (300) comprises shaping an electrically conducting material free of a bending process and/or free of a stamping process and by casting, injection molding, sintering and/or additive manufacturing to form the at least one electrical conductor (42, 44), and
the at least one electrical conductor (42, 44)
is monolithically formed from an electrically conducting material,
has a porous surface and/or is porous inside,
has a contact surface (46) configured for electrical connection to the substrate structure (20), and
extends monolithically from the contact surface (46) to the external electrical interface (2, 4).

13. Method according to the preceding claim, wherein the electrically conducting material comprises aluminum, copper and/or a polymer compound.

14. Method according to one of the preceding two claims, comprising
heating the electrically conducting material by casting, injection molding, sintering and/or additive manufacturing to a temperature of at least 200 °C and/or up to 1500 °C, wherein the electrically conducting material melts or does not melt.

15. Method according to one of the preceding three claims, comprising the step(s) of
coupling (400) the at least one electrical conductor (42, 44) to the substrate structure (20) by means of soldering and/or welding, especially at a contact surface (46) of the at least one electrical conductor (42, 44), and/or
attaching (500) the module housing (10) to the substrate structure (20) by means of screwing and/or bonding, especially after coupling (400).

## Patentansprüche

1. Leistungshalbleitermodul (1), umfassend
ein Modulgehäuse (10),
eine Substratstruktur (20) mit mindestens einer Metallisierungsschicht (22, 23) und mindestens einer Leistungshalbleitervorrichtung (24), die elektrisch mit der mindestens einen Metallisierungsschicht (22, 23) verbunden ist, wobei die Substratstruktur (20) an dem Modulgehäuse (10) angebracht ist, um die Leistungshalbleitervorrichtung (24) unterzubringen, und
eine Anschlussstruktur (40), die elektrisch mit der Substratstruktur (20) verbunden und zum Bereitstellen einer externen elektrischen Schnittstelle (2, 4) des Leistungshalbleitermoduls (1) für eine Hauptleistungsübertragung und/oder für eine Steuersignalübertragung der Substratstruktur (20) konfiguriert ist, wobei
die Anschlussstruktur (40) mindestens einen elektrischen Leiter (42, 44) aufweist, der durch Gießen, Spritzgießen, Sintern und/oder additive Fertigung geformt wird, und
der mindestens eine elektrische Leiter (42, 44) ohne Biegen und/oder Stanzen geformt wird und
der mindestens eine elektrische Leiter (42, 44)
monolithisch aus einem elektrisch leitenden Material gebildet ist,
eine poröse Oberfläche und/oder poröse Innenseite aufweist,
eine Kontaktfläche (46) aufweist, die zur elektrischen Verbindung mit der Substratstruktur (20) konfiguriert ist, und
sich monolithisch von der Kontaktfläche (46) zu der externen elektrischen Oberfläche (2, 4) erstreckt.

2. Leistungshalbleitermodul (1) nach einem der vorhergehenden Ansprüche, wobei das Modulgehäuse (10) mindestens einen Durchgang (12, 14) für den mindestens einen elektrischen Leiter (42, 44) aufweist und
sich der mindestens eine elektrische Leiter (42, 44) in ein Inneres (6) des Leistungshalbleitermoduls (1) von der Substratstruktur (20) zu einem Äußeren (8) des Leistungshalbleitermoduls (1) erstreckt, um die externe elektrische Schnittstelle (2, 4) zu bilden,
wobei insbesondere der mindestens eine elektrische Leiter (42, 44) von dem Modulgehäuse (10) in dem mindestens einen Durchgang (12, 14) umgeben ist und/oder wobei das Modulgehäuse (10) das Innere (6) bildet.

3. Leistungshalbleitermodul (1) nach einem der vorhergehenden Ansprüche, wobei das elektrisch leitende Material Graphit und/oder elektrisch leitende Polymerverbindung und/oder Metall, insbesondere eine Metalllegierung und/oder eine Metallverbindung, umfasst oder daraus besteht.

4. Leistungshalbleitermodul (1), nach einem der vorhergehenden Ansprüche,
wobei der mindestens eine elektrische Leiter (42, 44) einen elektrisch nicht leitenden Kern umfasst, der eine elektrisch leitende Oberflächenschicht aufweist, wobei die elektrisch leitende Oberflächenschicht insbesondere Nickel, Kupfer, Chrom, Eisen und/oder Kohlenstoff umfasst.

5. Leistungshalbleitermodul (1) nach einem der vorhergehenden Ansprüche, wobei der mindestens eine elektrische Leiter (42, 44) aus Metallpartikeln geformt ist und wobei eine Porosität des mindestens einen elektrischen Leiters (42, 44) mindestens 0,1 % und bis zu 10 % beträgt und/oder geschlossene Poren aufweist.

6. Leistungshalbleitermodul (1) nach einem der vorhergehenden Ansprüche, wobei der mindestens eine elektrische Leiter (42, 44) Aluminium umfasst oder aus einer Aluminiumlegierung besteht.

7. Leistungshalbleitermodul (1) nach einem der vorhergehenden Ansprüche, wobei der mindestens eine elektrische Leiter (42, 44) Kupfer umfasst oder aus einer Kupferlegierung besteht.

8. Leistungshalbleitermodul (1) nach einem der vorhergehenden Ansprüche, wobei der mindestens eine elektrische Leiter (42, 44) eine Polymerverbindung umfasst.

9. Leistungshalbleitermodul (1) nach einem der vorhergehenden Ansprüche, wobei der mindestens eine elektrische Leiter (42, 44) zwei oder mehr Teilstücke (S1, S2, S3) mit unterschiedlichen Dicken aufweist und/oder eine Dickenvariable, insbesondere um mindestens 10 %, entlang seiner Ausdehnung aufweist.

10. Leistungshalbleitermodul (1), nach einem der vorhergehenden Ansprüche, wobei die Kontaktfläche (46) eine Oberflächenrauigkeit aufweist, die geringer als andere Oberflächen des mindestens einen elektrischen Leiters (42, 44) ist und/oder mit einem Schneidprozess fertigbearbeitet wird.

11. Anschlussstruktur (40), die für das Leistungshalbleitermodul (1) nach einem der vorhergehenden Ansprüche konfiguriert ist, wobei
die Anschlussstruktur (40) dazu konfiguriert ist, elektrisch mit der Substratstruktur (20) verbunden zu sein und die externe elektrische Schnittstelle (2, 4) bereitzustellen, und
die Anschlussstruktur (40) mindestens einen elektrischen Leiter (42, 44) aufweist, der durch Gießen, Spritzgießen, Sintern und/oder additive Fertigung geformt wird, und
der mindestens eine elektrische Leiter (42, 44) ohne Biegen und/oder Stanzen geformt wird und
der mindestens eine elektrische Leiter (42, 44)
monolithisch aus einem elektrisch leitenden Material gebildet ist,
eine poröse Oberfläche und/oder poröse Innenseite aufweist,
eine Kontaktfläche (46) aufweist, die zur elektrischen Verbindung mit der Substratstruktur (20) konfiguriert ist, und
sich monolithisch von der Kontaktfläche (46) zu der externen elektrischen Oberfläche (2, 4) erstreckt.

12. Verfahren zum Herstellen eines Leistungshalbleitermoduls (1) nach Anspruch 1, umfassend die Schritte des
Bereitstellens (100) einer Substratstruktur (20) mit mindestens einer Leistungshalbleitervorrichtung (24),
Bereitstellens (200) eines Modulgehäuses (10), das dazu konfiguriert ist, an der Substratstruktur (20) angebracht zu werden, um die mindestens eine Leistungshalbleitervorrichtung (24) unterzubringen,
Herstellens (300) einer Anschlussstruktur (40), die mindestens einen elektrischen Leiter (42, 44) aufweist und dazu konfiguriert ist, elektrisch an die mindestens eine Leistungshalbleitervorrichtung (24) gekoppelt zu werden und eine externe elektrische Schnittstelle (2, 4) für eine Hauptleistungsübertragung und/oder für eine Steuersignalübertragung an die Substratstruktur (20) bereitzustellen,
Koppelns (400) des mindestens einen elektrischen Leiters (42, 44) an die Substratstruktur (20),
Anbringens (500) des Modulgehäuses (10) an die Substratstruktur (20),
wobei
das Herstellen (300) Formen eines elektrisch leitenden Materials ohne Biegeprozess und/oder ohne Stanzprozess und durch Gießen, Spritzgießen, Sintern und/oder additive Fertigung umfasst, um den mindestens einen elektrischen Leiter (42, 44) zu bilden, und
der mindestens eine elektrische Leiter (42, 44)
monolithisch aus einem elektrisch leitenden Material gebildet ist,
eine poröse Oberfläche und/oder poröse Innenseite aufweist,
eine Kontaktfläche (46) aufweist, die zur elektrischen Verbindung mit der Substratstruktur (20) konfiguriert ist, und
sich monolithisch von der Kontaktfläche (46) zu der externen elektrischen Oberfläche (2, 4) erstreckt.

13. Verfahren nach einem der vorhergehenden Ansprüche, wobei das elektrisch leitenden Material Aluminium, Kupfer und/oder eine Polymerverbindung umfasst.

14. Verfahren nach einem der vorhergehenden zwei Ansprüche, umfassend
Erhitzen des elektrisch leitenden Materials durch Gießen, Spritzgießen, Sintern und/oder additive Fertigung auf eine Temperatur von mindestens 200 °C und/oder bis zu 1500 °C, wobei das elektrisch leitende Material schmilzt oder nicht schmilzt.

15. Verfahren nach einem der vorhergehenden drei Ansprüche, umfassend den/die Schritt(e) des
Koppelns (400) des mindestens einen elektrischen Leiters (42, 44) an die Substratstruktur (20) mittels Löten und/oder Schweißen, insbesondere an einer Kontaktfläche (46) des mindestens einen elektrischen Leiters (42, 44), und/oder
Anbringens (500) des Modulgehäuses (10) an die Substratstruktur (20), insbesondere mittels Schrauben und/oder Verbinden, insbesondere nach dem Koppeln (400).

## Revendications

1. Module de semi-conducteur de puissance (1) comprenant
un boîtier de module (10),
une structure de substrat (20) avec au moins une couche de métallisation (22, 23) et au moins un dispositif semi-conducteur de puissance (24) connecté électriquement à au moins une couche de métallisation (22, 23), laquelle structure de substrat (20) est attachée au boîtier de module (10) pour accueillir le dispositif semi-conducteur de puissance (24), et
une structure de bornier (40) connectée électriquement à la structure de substrat (20) et configurée pour fournir une interface électrique externe (2, 4) du module de semi-conducteur de puissance (1) pour transmission de puissance secteur et/ou pour transmission de signal de commande de la structure de substrat (20), dans lequel
la structure de bornier (40) a au moins un conducteur électrique (42, 44) façonné par moulage, moulage par injection, frittage et/ou fabrication additive, et
l'au moins un conducteur électrique (42, 44) est façonné exempt de flexion et/ou exempt d'estampage et
l'au moins un conducteur électrique (42, 44)
est formé de manière monolithique à partir d'un matériau électriquement conducteur,
a une surface poreuse et/ou est poreux à l'intérieur,
a une surface de contact (46) configurée pour la connexion électrique à la structure de substrat (20), et
s'étend de manière monolithique depuis la surface de contact (46) jusqu'à l'interface électrique externe (2, 4).

2. Module de semi-conducteur de puissance (1) selon la revendication précédente, dans lequel
le boîtier de module (10) a au moins un passage (12, 14) pour l'au moins un conducteur électrique (42, 44), et
l'au moins un conducteur électrique (42, 44) s'étend dans un intérieur (6) du module de semi-conducteur de puissance (1) depuis la structure de substrat (20) jusqu'à un extérieur (8) du module de semi-conducteur de puissance (1) pour former l'interface électrique externe (2, 4),
en particulier dans lequel l'au moins un conducteur électrique (42, 44) est entouré par le boîtier de module (10) dans l'au moins un passage (12, 14) et/ou dans lequel le boîtier de module (10) forme l'intérieur (6).

3. Module de semi-conducteur de puissance (1) selon l'une quelconque des revendications précédentes, dans lequel le matériau électriquement conducteur comprend ou est constitué de graphite et/ou d'un composé polymère électriquement conducteur et/ou d'un métal, en particulier d'un alliage métallique et/ou d'un composé métallique.

4. Module de semi-conducteur de puissance (1) selon l'une des revendications précédentes,
dans lequel l'au moins un conducteur électrique (42, 44) comprend un noyau électriquement non conducteur qui a une couche de surface électriquement conductrice, spécialement la couche de surface électriquement conductrice comprenant du nickel, du cuivre, du chrome, du fer et/ou du carbone.

5. Module de semi-conducteur de puissance (1) selon l'une des revendications précédentes,
dans lequel l'au moins un conducteur électrique (42, 44) est façonné à partir de particules métalliques, et dans lequel une porosité de l'au moins un conducteur électrique (42, 44) est d'au moins 0,1 % et jusqu'à 10 % et/ou a des pores fermés.

6. Module de semi-conducteur de puissance (1) selon l'une des revendications précédentes,
dans lequel l'au moins un conducteur électrique (42, 44) comprend de l'aluminium ou est constitué d'un alliage d'aluminium.

7. Module de semi-conducteur de puissance (1) selon l'une des revendications précédentes,
dans lequel l'au moins un conducteur électrique (42, 44) comprend du cuivre ou est constitué d'un alliage de cuivre.

8. Module de semi-conducteur de puissance (1) selon l'une des revendications précédentes,
dans lequel l'au moins un conducteur électrique (42, 44) comprend un composé polymère.

9. Module de semi-conducteur de puissance (1) selon l'une des revendications précédentes,
dans lequel l'au moins un conducteur électrique (42, 44) a deux sections (S1, S2, S3) ou plus d'épaisseur différente et/ou a une épaisseur variable, en particulier d'au moins 10 % le long de son extension.

10. Module de semi-conducteur de puissance (1) selon l'une des revendications précédentes, dans lequel
la surface de contact (46) a une rugosité de surface inférieure à celle des autres surfaces de l'au moins un conducteur électrique (42, 44) et/ou est finie par usinage avec un processus de découpe.

11. Structure de bornier (40) configurée pour le module de semi-conducteur de puissance (1) selon l'une quelconque des revendications précédentes, dans lequel
la structure de bornier (40) est configurée pour être connectée électriquement à la structure de substrat (20) et pour fournir l'interface électrique externe (2, 4), et
la structure de bornier (40) a au moins un conducteur électrique (42, 44) façonné par moulage, moulage par injection, frittage et/ou fabrication additive, et l'au moins un conducteur électrique (42, 44) est façonné exempt de flexion et/ou exempt d'estampage et
l'au moins un conducteur électrique (42, 44)
est formé de manière monolithique à partir d'un matériau électriquement conducteur,
a une surface poreuse et/ou est poreux à l'intérieur,
a une surface de contact (46) configurée pour la connexion électrique à la structure de substrat (20), et
s'étend de manière monolithique depuis la surface de contact (46) jusqu'à l'interface électrique externe (2, 4).

12. Procédé de fabrication d'un module de semi-conducteur de puissance (1) selon la revendication 1, comprenant les étapes consistant à
fournir (100) une structure de substrat (20) avec au moins un dispositif de semi-conducteur de puissance (24),
fournir (200) un boîtier de module (10) configuré pour être attaché à la structure de substrat (20) afin d'accueillir l'au moins un dispositif semi-conducteur de puissance (24),
fabriquer (300) une structure de bornier (40) ayant au moins un conducteur électrique (42, 44) et configurée pour être couplée électriquement à au moins un dispositif semi-conducteur de puissance (24) et pour fournir une interface électrique externe (2, 4) pour transmission de puissance secteur et/ou pour transmission de signal de commande à la structure de bornier (20),
coupler (400) l'au moins un conducteur électrique (42, 44) à la structure de substrat (20),
attacher (500) le boîtier de module (10) à la structure de substrat (20), dans lequel
l'étape consistant à fabriquer (300) comprend une étape consistant à façonner un matériau électriquement conducteur exempt d'un processus de flexion et/ou exempt d'un processus d'estampage et par moulage, moulage par injection, frittage et/ou fabrication additive pour former l'au moins un conducteur électrique (42, 44), et
l'au moins un conducteur électrique (42, 44)
est formé de manière monolithique à partir d'un matériau électriquement conducteur,
a une surface poreuse et/ou est poreux à l'intérieur,
a une surface de contact (46) configurée pour la connexion électrique à la structure de substrat (20), et
s'étend de manière monolithique depuis la surface de contact (46) jusqu'à l'interface électrique externe (2, 4).

13. Procédé selon la revendication précédente, dans lequel le matériau électriquement conducteur comprend de l'aluminium, du cuivre et/ou un composé polymère.

14. Procédé selon l'une des deux revendications précédentes, comprenant les étapes consistant à
chauffer le matériau électriquement conducteur par moulage, moulage par injection, frittage et/ou fabrication additive jusqu'à une température d'au moins 200 °C et/ou jusqu'à 1500 °C, dans lequel le matériau électriquement conducteur fond ou ne fond pas.

15. Procédé selon l'une des trois revendications précédentes, comprenant la ou les étapes consistant à
coupler (400) l'au moins un conducteur électrique (42, 44) à la structure de substrat (20) par brasage et/ou soudage, spécialement au niveau d'une surface de contact (46) de l'au moins un conducteur électrique (42, 44), et/ou
attacher (500) le boîtier de module (10) à la structure de substrat (20) par vissage et/ou collage, spécialement après couplage (400).
